# EUROPEAN PATENT APPLICATION

(11) **EP 4 664 601 A1**
(43) Date of publication of application: **17.12.2025**
(21) Application number: 23934923.6
(22) Date of filing: 13.10.2023
(51) Int. Cl.: H01M 10/44, H01M 10/0525

(54) **BATTERY AND CHARGING METHOD THEREFOR, BATTERY MANAGEMENT SYSTEM, AND ELECTRICAL DEVICE**

(30) Priority: 27.04.2023 WO PCT/CN2023/091302
(71) Applicant: Contemporary Amperex Technology Co., Limited, Ningde, Fujian 352100 (CN)
(72) Inventor: JI, Cheng, Ningde, Fujian 352100 (CN); LI, Baiqing, Ningde, Fujian 352100 (CN)
(74) Representative: Lorenz Seidler Gossel Part. mbB
(86) International application number: PCT/CN2023/124524
(87) International publication number: WO 2024/221754

(57) **Abstract**

This application provides a battery and a charging method thereof, a battery management system, and an electric device, capable of improving charging performance of the battery. The battery includes at least one battery cell and a battery management system. A positive electrode active material of the battery cell includes LiMPO₄, and M includes element Mn and element Fe. The battery management system is configured to: when an SOC of the battery is less than or equal to a preset SOC threshold, control the battery to charge based on a first charging current so as to heat the battery during a charging process; and when the SOC of the battery is greater than the SOC threshold, control the battery to charge based on a second charging current, where the first charging current is greater than the second charging current.

## Description

This application claims priority to the PCT application No. PCT/CN2023/091302 filed with the China National Intellectual Property Administration on April 27, 2023 and entitled "CHARGING METHOD AND APPARATUS, ELECTRONIC DEVICE, AND COMPUTER-READABLE STORAGE MEDIUM", which is incorporated herein by reference in its entirety.

### TECHNICAL FIELD

This application relates to the field of battery technology, and particularly, to a battery and a charging method thereof, a battery management system, and an electric device.

### BACKGROUND

With the development of the times, electric vehicles, due to advantages such as high environmental friendliness, low noise, and low operating costs, have significant market prospects and can effectively promote energy conservation and emission reduction, benefiting societal development and progress.

For electric vehicles, battery technology is a critical factor influencing their development. Therefore, how to enhance charging performance of batteries has become an urgent issue to address.

### SUMMARY

This application provides a battery and a charging method thereof, a battery management system, and an electric device, capable of improving the charging performance of the battery.

According to a first aspect, a battery is provided, including at least one battery cell and a battery management system. A positive electrode active material of the battery cell includes LiMPO₄, and M includes element Mn and element Fe. The battery management system is configured to: during at least a portion of a period when an SOC of the battery is less than or equal to a preset SOC threshold, control the battery to charge based on a first charging current so as to heat the battery during the charging process; and during at least a portion of a period when the SOC of the battery is greater than the SOC threshold, control the battery to charge based on a second charging current, where the first charging current is greater than the second charging current.

The battery in this application adopts the LiMPO₄ material as the positive electrode active material, where M includes the element Mn and the element Fe, offering advantages such as high energy density and large capacity. However, when the LiMPO₄ material serves as the positive electrode active material of the battery, the charging process sequentially undergoes a charging plateau corresponding to the element Fe and a charging plateau corresponding to the element Mn. During the charging plateau stage corresponding to the element Mn, a delithiation depth of the positive electrode active material is low, making it difficult to fully utilize the capacity of the battery. To address this, when the SOC of the battery is less than or equal to the preset SOC threshold, the battery management system controls the battery to charge based on the larger first charging current, increasing the temperature of the battery during the charging process; and when the SOC of the battery exceeds the SOC threshold, control the battery to charge based on the conventional second charging current. In this way, upon entering the charging plateau stage corresponding to the element Mn, the battery has an appropriate temperature, capable of enhancing the delithiation depth of the positive electrode active material LiMPO₄, thereby increasing the charging capacity of the battery and improving the charging performance of the battery.

In some possible implementations, the first charging current is configured to decrease with the SOC of the battery.

In this implementation, as the SOC of the battery increases, the charging capability of the battery, such as a maximum allowable charging current, gradually decreases. To reduce occurrences such as lithium precipitation caused by the charging current exceeding the maximum allowable charging current of the battery during the charging process, the first charging current needs to be adjusted in real-time as the SOC of the battery increases during the charging process.

In some possible implementations, a range less than or equal to the SOC threshold includes multiple SOC intervals, where the multiple SOC intervals respectively correspond to multiple current values of the first charging current. The battery management system is specifically configured to determine a target current value corresponding to a target SOC interval, based on correspondences between the multiple SOC intervals and the multiple current values and the target SOC interval in which the SOC of the battery is located; and when the SOC of the battery is within the target SOC interval, control the battery to charge based on the target current value.

In this implementation, before the SOC of the battery reaches the SOC threshold, the multiple SOC intervals are set, where the multiple SOC intervals respectively correspond to the multiple current values of the first charging current. The battery management system determines, based on an SOC interval in which a current SOC of the battery is located, a corresponding current value for charging the battery, thereby effectively reducing occurrences such as lithium precipitation caused by the current exceeding the maximum allowable charging current of the battery during the charging process.

In some possible implementations, a length of the SOC interval is between 3% to 10%.

In this implementation, a smaller length of each SOC interval means a larger current value corresponding to a maximum SOC value within each SOC interval, leading to a greater temperature rise in the battery. Conversely, a larger length of the SOC interval means lower control complexity of the battery management system. Therefore, setting the length of the SOC interval between 3% to 10% can meet the temperature rise requirements of the battery without increasing the control complexity of the battery management system.

In some possible implementations, a current value corresponding to each SOC interval among the multiple SOC intervals is less than or equal to a maximum allowable charging current of the battery corresponding to a maximum SOC value within each SOC interval.

In this implementation, as the SOC of the battery increases, the maximum allowable charging current of the battery gradually decreases. To reduce occurrences such as lithium precipitation caused by the charging current exceeding the maximum allowable charging current of the battery during the charging process, the current value of the first charging current corresponding to each SOC interval should be less than or equal to the maximum allowable charging current of the battery corresponding to the maximum SOC value within that SOC interval.

In some possible implementations, the SOC threshold is determined based on a molar ratio of the element Fe in iron-manganese elements of the positive electrode active material. For example, the SOC threshold is a product of an SOC of the battery in a fully charged state and the molar ratio.

In this implementation, the SOC threshold can be determined based on the molar ratio of the element Fe in the iron-manganese elements of the positive electrode active material, enabling the battery to have an appropriate temperature when reaching the charging plateau corresponding to the element Mn, thereby effectively improving the charging performance of the battery and reducing unnecessary power consumption.

In some possible implementations, the second charging current is a constant current. That is, after the SOC exceeds the SOC threshold, the battery is charged in a manner of constant current charging, offering advantages such as high charging efficiency, ease of precise control, and reduction in battery damage caused by overcharging, fast charging or the like, thereby extending the battery lifespan.

In some possible implementations, a capacity of the battery cell is between 100 Ah to 300 Ah, or between 130 Ah to 250 Ah. A battery cell of a larger capacity generates more heat, meaning a higher temperature when the battery reaches the SOC threshold. This is more conducive to utilizing the capacity of the battery cell.

In some possible implementations, the positive electrode active material includes at least one of the following materials:
LiMn_{1-y}Fe_{y}PO₄, where y is any value in a range of 0.001 to 0.5;
Li₁₊ₜMn_{1-c}Fe_{c}P_{1-z}R_{z}O₄, where t is any value in a range of -0.100 to 0.100, c is any value in a range of 0.001 to 0.500, z is any value in a range of 0.001 to 0.100, and R includes one or more elements selected from B, S, Si, and N; and
Li_{1+w}CₘMn₁₋ᵤFeᵤP₁₋ₐRₐO₄₋ₙDₙ, where C includes one or more elements selected from Zn, Al, Na, K, Mg, Nb, Mo, and W, R includes one or more elements selected from B, S, Si, and N, D includes one or more elements selected from S, F, Cl, and Br, w is any value in a range of -0.100 to 0.100, u is any value in a range of 0.001 to 0.500, a is any value in a range of 0.001 to 0.100, n is any value in a range of 0.001 to 0.1, and m is any value in a range of 0.9 to 1.1.

According to a second aspect, a charging method of a battery is provided, where the battery includes at least one battery cell, a positive electrode active material of the battery cell includes LiMPO₄, and M includes element Mn and element Fe. The charging method includes: during at least a portion of a period when an SOC of the battery is less than or equal to a preset SOC threshold, controlling the battery to charge based on a first charging current, so as to heat the battery during the charging process; and during at least a portion of a period when the SOC of the battery is greater than the SOC threshold, controlling the battery to charge based on a second charging current, where the first charging current is greater than the second charging current.

In some possible implementations, the first charging current is configured to decrease with the SOC of the battery.

In some possible implementations, a range less than or equal to the SOC threshold includes multiple SOC intervals, where the multiple SOC intervals respectively correspond to multiple current values of the first charging current. The charging method further includes: determining a target current value corresponding to a target SOC interval, based on correspondences between the multiple SOC intervals and the multiple current values and the target SOC interval in which the SOC of the battery is located; and the controlling the battery to charge based on a first charging current includes: when the SOC of the battery is within the target SOC interval, controlling the battery to charge based on the target current value.

In some possible implementations, a length of the SOC interval is between 3% to 10%.

In some possible implementations, a current value corresponding to each SOC interval among the multiple SOC intervals is less than or equal to a maximum allowable charging current of the battery corresponding to a maximum SOC value within each SOC interval.

In some possible implementations, the SOC threshold is determined based on a molar ratio of the element Fe in iron-manganese elements of the positive electrode active material. For example, the SOC threshold is a product of an SOC of the battery in a fully charged state and the molar ratio.

In some possible implementations, the second charging current is a constant current.

In some possible implementations, a capacity of the battery cell is between 100 Ah to 300 Ah, or between 130 Ah to 250 Ah.

In some possible implementations, the positive electrode active material includes at least one of the following materials:
LiMn_{1-y}Fe_{y}PO₄, where y is any value in a range of 0.001 to 0.5;
Li₁₊ₜMn_{1-c}Fe_{c}P_{1-z}R_{z}O₄, where t is any value in a range of -0.100 to 0.100, c is any value in a range of 0.001 to 0.500, z is any value in a range of 0.001 to 0.100, and R includes one or more elements selected from B, S, Si, and N; and
Li_{1+w}CₘMn₁₋ᵤFeᵤP₁₋ₐRₐO₄₋ₙDₙ, where C includes one or more elements selected from Zn, Al, Na, K, Mg, Nb, Mo, and W, R includes one or more elements selected from B, S, Si, and N, D includes one or more elements selected from S, F, Cl, and Br, w is any value in a range of -0.100 to 0.100, u is any value in a range of 0.001 to 0.500, a is any value in a range of 0.001 to 0.100, n is any value in a range of 0.001 to 0.1, and m is any value in a range of 0.9 to 1.1.

According to a third aspect, a battery management system is provided, configured to perform the charging method of the battery described in the first aspect or any possible implementation of the first aspect, where the battery includes at least one battery cell, a positive electrode active material of the battery cell includes LiMPO₄, and M includes element Mn and element Fe.

According to a fourth aspect, an electric device is provided, including the battery described in the first aspect or any possible implementation of the first aspect.

According to a fifth aspect, a charging device is provided, including a processor and a memory, where the memory is configured to store a computer program, and the processor is configured to call and run the computer program stored in the memory to perform the method described in the second aspect or any possible implementation of the second aspect.

According to a sixth aspect, a computer-readable storage medium is provided, configured to store a computer program, where when the computer program is executed by a computing device, the computing device implements the method described in the second aspect or any possible implementation of the second aspect.

### BRIEF DESCRIPTION OF DRAWINGS

To more clearly illustrate the technical solutions of the embodiments of this application, the drawings required for use in the embodiments of this application are briefly introduced below. It is apparent that the drawings described below are merely some embodiments of this application. For those of ordinary skill in the art, other drawings can be obtained based on these drawings without creative effort.
FIG. 1 is a schematic block diagram of a charging system to which an embodiment of this application may be applied.
FIG. 2 is a schematic block diagram of a battery according to an embodiment of this application.
FIG. 3 is a schematic flowchart of a charging method of a battery according to an embodiment of this application.
FIG. 4 is a flowchart interaction diagram of a possible implementation of the charging method of the battery shown in FIG. 3.
FIG. 5 is a schematic diagram of an electric device according to an embodiment of this application.

### DESCRIPTION OF EMBODIMENTS

To make the objectives, technical solutions, and advantages of some embodiments of this application clearer, the following clearly describes the technical solutions in some embodiments of this application with reference to the accompanying drawings in some embodiments of this application. Apparently, these embodiments described are some rather than all embodiments of this application. All other embodiments obtained by a person of ordinary skill in the art based on the embodiments of this application without creative efforts shall fall within the protection scope of this application.

Unless otherwise defined, all technical and scientific terms used in this application shall have the same meanings as commonly understood by those skilled in the art to which this application relates. The terms used in the specification of this application are intended to merely describe the specific embodiments rather than to limit this application. The terms "include", "have", and any variations thereof in the specification and claims of this application as well as the foregoing description of drawings are intended to cover non-exclusive inclusions. In the specification, claims, or accompanying drawings of this application, the terms "first", "second", and the like are intended to distinguish between different objects rather than to indicate a particular order or relative importance. "Perpendicular" is not perpendicular in the strict sense but within an allowable range of error. "Parallel" is not parallel in the strict sense but within an allowable range of error.

Reference to "embodiment" in this application means that specific features, structures, or characteristics described with reference to the embodiment may be included in at least one embodiment of this application. The word "embodiment" appearing in various places in the specification does not necessarily refer to the same embodiment or an independent or alternative embodiment that is exclusive of other embodiments. It is explicitly or implicitly understood by persons skilled in the art that the embodiments described in this application may be combined with other embodiments.

In the description of this application, it should be noted that unless otherwise specified and defined explicitly, the terms "mount", "connect", "join", and "attach" should be understood in their general senses. For example, they may refer to a fixed connection, a detachable connection, or an integral connection, and may refer to a direct connection, an indirect connection via an intermediate medium, or an internal communication between two elements. Persons of ordinary skills in the art can understand specific meanings of these terms in this application as appropriate to specific situations.

The term "and/or" in this application is only an associative relationship for describing associated objects, indicating that three relationships may be present. For example, A and/or B may indicate three cases: presence of only A; presence of both A and B; and presence of only B. In addition, the character "/" in this application indicates an "or" relationship between contextually associated objects.

In some embodiments of this application, like reference signs denote like components, and for brevity, in different embodiments, detailed descriptions of like components are not repeated. It should be understood that, as shown in the accompanying drawings, sizes such as thickness, length, and width of various members and sizes such as thickness, length, and width of integrated devices in the embodiments of this application are merely for illustrative purposes and should not constitute any limitations on this application.

A generally is a single physical module that includes one or more battery cells for providing a higher voltage and capacity. For example, the battery may be a battery module, where multiple battery cells are arranged and fixed to form one battery module. For another example, the battery may be a battery pack, where the battery includes battery cells and a box, and the battery cells or battery module is accommodated within the box.

The technical solutions described in this embodiment of this application are all applicable to various apparatuses that use batteries, for example, cell phones, portable devices, laptop computers, battery scooters, electric toys, power tools, electric vehicles, ships, and spacecraft, for example, spacecraft including aircraft, rockets, space shuttles, and spacecraft.

It should be understood that the technical solutions described in this embodiment of this application are not limited to the apparatus described above, and can be applied to all apparatuses that use batteries, but for the sake of concise description, in the following embodiments, the electric vehicle is used as an example.

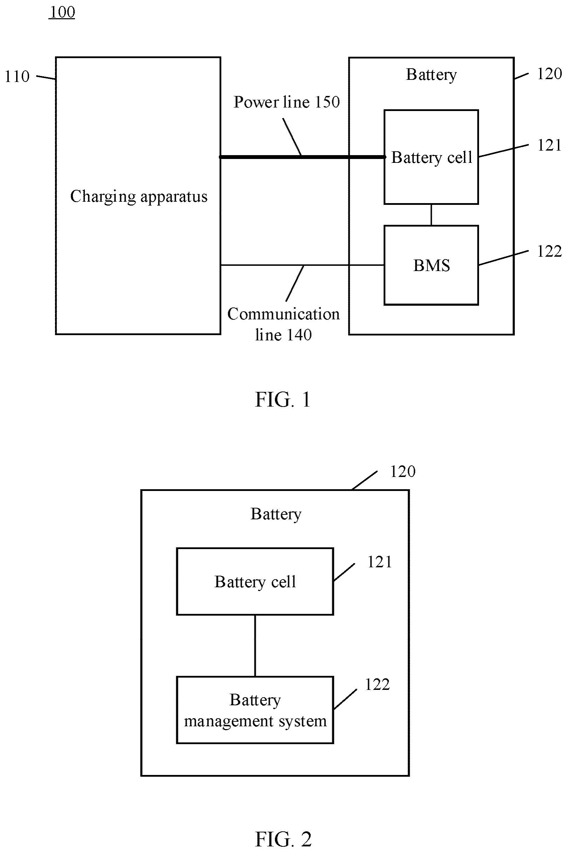

FIG. 1 is an architecture diagram of a charging system 100 to which an embodiment of this application is applicable. As shown in FIG. 1, the charging system 100 includes a charging apparatus 110 and a battery 120. Optionally, the battery 120 may be a battery in an electric device, such as a vehicle, or a battery in other application scenarios.

Optionally, the battery 120 includes a battery cell 121 and a battery management system (battery management system, BMS) 122. The BMS 122 is configured to monitor a state of the battery cell 121, perform intelligent management and maintenance on the battery cell 121, and reduce the probability of overcharging, over-discharging, and the like of the battery 120.

The charging apparatus 110 is configured to supply electrical energy to the battery cell 121 in the battery 120 and/or control discharging of the battery cell 121. For example, the charging and discharging apparatus 110 may be a regular charging pile, a supercharging pile, a charging pile supporting a vehicle-to-grid (vehicle-to-grid, V2G) mode, a charger, or other apparatuses used for charging and/or discharging the battery. A specific type and specific application scenario of the charging apparatus 110 are not limited in the embodiments of this application.

Optionally, as shown in FIG. 1, the charging and discharging apparatus 110 is connected to the battery cell 121 through a power line 150 and connected to the BMS 122 through a communication line 140, where the communication line 140 is configured to enable information interaction between the charging apparatus 110 and the BMS 122. For example, the communication line 140 includes, but is not limited to, a controller area network (controller area network, CAN) communication bus or a daisy chain (daisy chain) communication bus.

Optionally, in addition to communicating with the BMS 122 through the communication line 140, the charging apparatus 110 may also communicate with the BMS 122 through a wireless network. The embodiments of this application do not specifically limit the type of wired communication or wireless communication between the charging apparatus 110 and the BMS 122.

As shown in FIG. 2, an embodiment of this application provides a battery 120, including at least one battery cell 121 and a battery management system 122. A positive electrode active material of the battery cell 121 is lithium manganese iron phosphate denoted as LiMPO₄ hereinafter, where M includes element Mn and element Fe. The battery management system 122 is configured to:
during at least a portion of a period when an SOC of the battery 120 is less than or equal to a preset SOC threshold, control the battery 120 to charge based on a first charging current, so as to heat the battery 120 during the charging process; and,
during at least a portion of a period when the SOC of the battery 120 is greater than the SOC threshold, control the battery 120 to charge based on a second charging current, where the first charging current is greater than the second charging current.

Herein, the battery management system 122 may be, for example, the BMS 122 shown in FIG. 1, or another control module capable of controlling a charging current of the battery 120.

The battery 120 includes at least one battery cell 121, where the positive electrode active material of the battery cell 121 is the LiMPO₄ material, and M in the LiMPO₄ material may include the element Mn and the element Fe. Compared with a conventional battery using a LiFePO₄ material as a positive electrode active material, the battery 120 using the LiMPO₄ material as the positive electrode active material has a higher voltage plateau, with an energy density approximately 15% higher than that of the battery using the LiFePO₄ material, offering advantages such as high energy density and large capacity, and featuring lower cost and higher safety.

However, when the LiMPO₄ material serves as the positive electrode active material of the battery 120, the charging process of the battery 120 sequentially undergoes a charging plateau corresponding to the element Fe and a charging plateau corresponding to the element Mn. During the charging plateau stage corresponding to the element Mn, a delithiation depth of the positive electrode active material is low, making it difficult to fully utilize a capacity of the battery 120. Additionally, a low delithiation speed of the positive electrode active material results in a lower charging speed of the battery, thereby affecting the charging performance of the battery 120 and reducing user experience.

To this end, in the embodiments of this application, when the SOC of the battery is less than or equal to the preset SOC threshold, the battery management system 122 controls the battery to charge based on the larger first charging current. When the first charging current passes through the battery 120, the battery 120 can generate heat due to its internal resistance. Therefore, the temperature of the battery can be increased during the charging process until the SOC of the battery exceeds the SOC threshold, the battery is controlled to charge based on the conventional second charging current, where the second charging current is less than the first charging current. In this way, upon entering the charging plateau stage corresponding to the element Mn, the battery 120 has an appropriate temperature, which helps increase a delithiation depth of the positive electrode active material LiMPO₄, thereby increasing a capacity of the battery 120. An appropriate temperature also facilitates an increase in a diffusion speed of lithium ions and a delithiation speed, which helps shorten a charging time of the battery 120, making it easier to meet fast-charging requirements. Therefore, to a certain extent, this addresses issues such as the difficulty in fully utilizing the capacity and low charging speed caused by using the LiMPO₄ material as the positive electrode active material of the battery 120.

It can be understood that in the embodiments of this application, the charging plateau refers to a stage in which an electrochemical reaction reaches a balanced state during the charging process. During the charging plateau, a potential of the battery fluctuates minimally with the SOC, or in other words, the potential of the battery remains relatively stable during the charging plateau.

In the embodiments of this application, during an entire period when the SOC is less than or equal to the preset SOC threshold, the battery 120 may be controlled to charge based on the first charging current, so as to heat the battery 120 through the first charging current. Alternatively, during a portion of the period when the SOC is less than or equal to the SOC threshold, the battery 120 may be controlled to charge based on the first charging current, so as to heat the battery 120 through the first charging current.

For example, when the SOC is less than or equal to the SOC threshold, the battery 120 may be controlled to charge based on the first charging current to heat the battery 120, and the battery 120 may be controlled to charge based on a third charging current. Optionally, the third charging current is less than the first charging current and greater than or equal to the second charging current. That is, during a portion of the period when the SOC is less than or equal to the SOC threshold, the battery 120 may be heated at the first charging current, and during another portion of the period, the battery 120 may be charged at the third charging current, to reduce damage to the battery 120 caused by prolonged large-current charging.

Optionally, during at least a portion of a stage when the SOC of the battery 120 is less than or equal to the SOC threshold, the battery 120 may alternatively be externally heated, and the external heating may at least partially overlap with the charging process of the battery 120. For example, during the process of charging the battery 120 based on the third charging current, the battery 120 is also heated in a manner of external heating.

In the embodiments of this application, during an entire period when the SOC is greater than the preset SOC threshold, the battery 120 may be controlled to charge based on the second charging current. Alternatively, during a portion of the period when the SOC is greater than the SOC threshold, the battery 120 may be controlled to charge based on the second charging current.

For example, when the SOC is greater than the SOC threshold, the battery 120 may be controlled to charge based on the second charging current, and the battery 120 may be controlled to charge based on a fourth charging current. Optionally, the fourth charging current is less than or equal to the first charging current and greater than the second charging current. The fourth charging current, for example, may be used to heat the battery 120. That is, when the SOC is greater than the SOC threshold, if the temperature of the battery 120 decreases after the battery 120 is charged based on the second charging current for a period, the battery 120 may be charged based on the fourth charging current to increase the temperature of the battery 120 again.

Certainly, during at least a portion of a stage when the SOC is greater than the SOC threshold, the battery 120 may alternatively be externally heated, and the external heating may at least partially overlap with the charging process of the battery 120. For example, when the SOC is greater than the SOC threshold, if the temperature of the battery 120 decreases after the battery 120 is charged based on the second charging current for a period, the battery 120 may also be heated in a manner of external heating.

In the embodiments of this application, the external heating manner refers to a manner of heating the battery 120 through an external heating apparatus of the battery 120. The heating apparatus may be, for example, a heating film, an active heating component such as a positive temperature coefficient (positive temperature coefficient, PTC) heating component or a high voltage heater (high voltage heater, HVH), or a passive heating device such as a heat pump. The temperature of the battery 120 is increased through heat transfer between the heating apparatus and the battery 120.

The state of charge (state of charge, SOC) of the battery 120 is used to indicate a remaining capacity of the battery 120, for example, a ratio of the remaining capacity of the battery 120 to a capacity of the battery 120. For example, to detect the SOC of the battery 120, an open circuit voltage (open circuit voltage, OCV) of the battery 120 may be detected, and based on a pre-established curve representing relationships between the voltages and the SOCs of the battery 120, namely an SOC-OCV curve, an SOC corresponding to a current detected OCV is searched for.

For the battery 120 using the LiMPO₄ material as the positive electrode active material, the charging process sequentially undergoes the charging plateau corresponding to the element Fe and the charging plateau corresponding to the element Mn. A direct current resistance (directive current resistance, DCR) of the battery 120 during the charging plateau corresponding to the element Mn is 1.5 to 2 times the DCR during the charging plateau corresponding to the element Fe, making it difficult for lithium ions to be released after the battery 120 reaches the charging plateau corresponding to the element Mn. When the SOC of the battery 120 is greater than the SOC threshold, the battery 120 has passed the charging plateau corresponding to the element Fe and entered the charging plateau corresponding to the element Mn. Since the temperature of the battery 120 has already increased during the charging process with the first charging current, delithiation of the positive electrode active material is facilitated during the charging plateau stage corresponding to the element Mn, thereby improving the charging performance of the battery 120.

As described above, since the charging process of the battery 120 sequentially undergoes the charging plateau corresponding to the element Fe and the charging plateau corresponding to the element Mn, and issues such as small delithiation depth occur during the charging plateau corresponding to the element Mn, in some embodiments, the SOC threshold may be determined based on a molar ratio f of the element Fe in iron-manganese elements of the positive electrode active material.

For example, a first SOC threshold may be a product of an SOC of the battery 120 in a fully charged state and the molar ratio f of the element Fe in the iron-manganese elements.

In the LiMPO₄ material, M includes Mn and Fe, the molar ratio f of the element Fe in the iron-manganese elements is equal to a ratio of a molar content of the element Fe to a total molar content of the element Fe and the element Mn.

It can be understood that the SOC of the battery 120 in the fully charged state is typically equal to 1. However, as the battery 120 experiences wear during use, the SOC of the battery 120 in the fully charged state may gradually decrease, becoming less than 1. To determine the SOC threshold, an actual SOC of the battery 120 in the fully charged state needs to be used. The actual SOC of the battery 120 in the fully charged state is multiplied by the molar ratio f of the element Fe in the iron-manganese elements to obtain the SOC threshold.

0 < f < 1, and optionally, 0.01 ≤ f ≤ 0.6.

A proportion f of the element Fe in the iron-manganese elements may be less than a proportion of the element Mn. For example, f may be in a range of 0.001 to 0.5. For example, f is equal to 0.001, 0.002, 0.003, 0.004, 0.005, 0.007, 0.008, 0.009, 0.01, 0.02, 0.05, 0.07, 0.1, 0.15, 0.2, 0.25, 0.3, 0.35, 0.4, 0.45, 0.49, or 0.5.

The proportion f of the element Fe in the iron-manganese elements may alternatively be slightly greater than the proportion of the element Mn. For example, f may be in a range of 0.5 to 0.6. For example, f is equal to 0.51, 0.52, 0.55, 0.57, 0.58, 0.59, or 0.6.

For example, if f = 0.3, the ratio of the element Fe to the element Mn in the LiMPO₄ material is 3:7, and the SOC threshold may be 30% of the SOC of the battery 120 in the fully charged state. When the SOC of the battery 120 is less than 30%, the battery 120 is charged at the first charging current, increasing the temperature of the battery 120 during the charging process of the battery 120. When the battery 120 is charged to an extent that the SOC thereof reaches 30% of the SOC in the fully charged state, it indicates that the battery 120 has passed the charging plateau corresponding to the element Fe and is about to enter the charging plateau corresponding to the element Mn. At this time, the temperature of the battery 120 has been increased to some extent. Therefore, the charging performance of the battery 120 during the charging plateau corresponding to the element Mn can be improved.

For another example, if f = 0.4, the ratio of Fe to Mn in the LiMPO₄ material is 4:6, and a first SOC threshold may be 40% of the SOC of the battery 120 in the fully charged state. When the SOC of the battery 120 is less than 40%, the battery 120 is charged at the first charging current, increasing the temperature of the battery 120 during the charging process of the battery 120. When the SOC of the battery 120 reaches 40% of the SOC thereof in the fully charged state, it indicates that the battery 120 has passed the charging plateau corresponding to the element Fe and is about to enter the charging plateau corresponding to the element Mn. At this time, the temperature of the battery 120 has been increased to some extent. Therefore, the charging performance of the battery 120 during the charging plateau corresponding to the element Mn can be improved.

It can be understood that during the process of charging the battery 120 based on the first charging current, when the first charging current passes through the battery 120, the battery 120 can generate heat due to its internal resistance, achieving self-heating of the battery 120, thereby increasing its temperature.

As the SOC of the battery increases, a charging capability of the battery 120 gradually decreases. To reduce occurrences such as lithium precipitation caused by the charging current exceeding the maximum allowable charging current of the battery 120 during the charging process, the first charging current needs to be adjusted in real-time based on an increase in the SOC of the battery 120 during the charging process. Therefore, in some embodiments, the first charging current may be configured to decrease with the SOC of the battery.

In some embodiments, a range less than or equal to the SOC threshold includes multiple SOC intervals, where the multiple SOC intervals respectively correspond to multiple current values of the first charging current. The battery management system 122 may determine a target current value corresponding to a target SOC interval, based on correspondences between the multiple SOC intervals and the multiple current values and the target SOC interval in which the SOC of the battery 120 is located, and charge the battery 120 with the target current value when the SOC of the battery 120 is within the target SOC interval.

That is, during the charging process, the SOC of the battery 120 gradually increases, and each time an SOC interval is reached, the current value of the first charging current needs to be adjusted. The battery management system 122 may determine a corresponding current value based on the SOC interval in which the current SOC of the battery 120 is located and the correspondences between the SOC intervals and the current values, ensuring that the current value of the first charging current matches the current SOC of the battery 120, thereby reducing occurrences such as lithium precipitation caused by the charging current exceeding the maximum allowable charging current of the battery 120 during the charging process.

In some embodiments, a current value of the first charging current corresponding to each SOC interval is less than or equal to a maximum allowable charging current of the battery 120 corresponding to a maximum SOC value within that SOC interval.

The maximum allowable charging current of the battery 120 is related to characteristics such as the material of the battery 120. For example, the maximum charging current is related to an electrolyte and graphite of the battery 120.

It can be understood that in the embodiments of this application, the current value of the first charging current corresponding to each SOC interval may be a current magnitude of the first charging current or a current range of the first charging current. That is, a corresponding current magnitude may be set for each SOC interval, or a corresponding current range may be set for each SOC interval. Typically, a magnitude of a charging current may be expressed as a charging rate. For example, the charging rate is equal to a ratio of the charging current to a rated capacity.

During the charging process of the battery 120, before the SOC thereof reaches the SOC threshold, each time the SOC of the battery 120 reaches an SOC interval, a current magnitude or current range of the first charging current needs to be adjusted to a current magnitude or current range corresponding to that SOC interval, and the battery 120 is charged based on that current magnitude or a current magnitude within that current range.

A smaller length of the SOC interval means a larger current value corresponding to a maximum SOC value within each SOC interval, leading to a greater temperature rise in the battery 120. Conversely, a larger length of the SOC interval means lower control complexity of the battery management system 122. Therefore, in some embodiments, the length of the SOC interval may be set between 3% to 10%, which can meet the temperature rise requirements of the battery 120 without increasing the control complexity of the battery management system 122.

In some embodiments, the range of the first charging current is determined based on a maximum allowable charging current of the battery 120 when the SOC of the battery 120 is at the SOC threshold and a maximum allowable charging current of the battery 120 when the SOC of the battery 120 is 0. For example, the range of the first charging current includes 0.36C to 4.92C. Further, optionally, the range of the first charging current includes 0.40C to 4.2C.

For example, it is assumed the SOC threshold is 45% and the length of the SOC interval is 5%. As shown in the correspondences between first charging currents and SOC intervals in Table 1, when the SOC of the battery 120 is less than or equal to 45%, the battery 120 is charged at the first charging current, and charging rates of the first charging current corresponding to the SOC intervals are different. After the SOC of the battery 120 reaches 45%, the battery 120 is charged at the second charging current, where the second charging current is less than the first charging current. Table 1 provides three possible correspondences between the first charging currents and SOC intervals, namely currents described in Example 1, Example 2, and Example 3.

**Table 1**

| SOC interval | Charging stage | Charging rate (C) | | |
|---|---|---|---|---|
| | | Example 1 | Example 2 | Example 3 |
| 0%-5% | First charging current | 4.10 | 2.00 | 1.50 |
| 5%-10% | | 3.53 | 1.80 | 1.20 |
| 10%-15% | | 2.95 | 1.70 | 1.10 |
| 15%-20% | | 2.50 | 1.40 | 0.80 |
| 20%-25% | | 2.05 | 1.20 | 0.80 |
| 25%-30% | | 1.79 | 0.80 | 0.70 |
| 30%-35% | | 1.54 | 0.70 | 0.50 |
| 35%-40% | | 1.18 | 0.50 | 0.40 |
| 40%-45% | | 1.09 | 0.40 | 0.40 |
| 45%-100% | Second charging current | 0.33 | 0.33 | 0.33 |

It can be seen that as the SOC increases, each time an SOC interval is reached, a battery management system 122 adjusts the first charging current to correspondingly reduce the first charging current. This reduces a probability of the charging current exceeding the maximum allowable charging current of the battery 120, lowers a probability of lithium precipitation in the battery 120, and extends the lifespan of the battery 120.

Example 1 is used as an example. When the SOC of the battery 120 is in a range of 0% to 5%, the battery 120 is charged at a charging rate of 4.1C. When the SOC of the battery 120 is charged to a range of 5% to 10%, the battery 120 is charged at a charging rate of 3.53C. When the SOC of the battery 120 is charged to a range of 10% to 15%, the battery 120 is charged at a charging rate of 2.95C. When the SOC of the battery 120 is charged to a range of 15% to 20%, the battery 120 is charged at a charging rate of 2.50C. When the SOC of the battery 120 is charged to a range of 20% to 25%, the battery 120 is charged at a charging rate of 2.05C. When the SOC of the battery 120 is charged to a range of 25% to 30%, the battery 120 is charged at a charging rate of 1.79C. When the SOC of the battery 120 is charged to a range of 30% to 35%, the battery 120 is charged at a charging rate of 1.54C. When the SOC of the battery 120 is charged to a range of 35% to 40%, the battery 120 is charged at a charging rate of 1.18C. When the SOC of the battery 120 is charged to a range of 40% to 45%, the battery 120 is charged at a charging rate of 1.09C. When the SOC of the battery 120 is charged to exceed 45%, the battery 120 is charged at a charging rate of 0.33C.

For another example, as shown in the correspondences between first charging currents and SOC intervals in Table 2, it is assumed that the SOC threshold is 45% and the length of the SOC interval is 5%. As shown in Table 2, when the SOC of the battery 120 is less than or equal to 45%, the battery 120 is charged at the first charging current, and the charging rate ranges of the first charging currents corresponding to the SOC intervals are different. After the SOC of the battery 120 reaches 45%, the battery 120 is charged at a second charging current, where the second charging current is less than the first charging current. Table 2 provides two possible correspondences between the first charging currents and SOC intervals, namely Example 1 and Example 2.

**Table 2**

| SOC interval | Charging stage | Charging rate range (C) | |
|---|---|---|---|
| | | Example 1 | Example 2 |
| 0%-5% | First charging current | 1.37-4.92 | 2.0-4.2 |
| 5%-10% | | 1.18-4.23 | 1.80-3.80 |
| 10%-15% | | 0.98-3.54 | 1.70-3.20 |
| 15%-20% | | 0.83-3.00 | 1.40-2.80 |
| 20%-25% | | 0.68-2.46 | 1.20-2.40 |
| 25%-30% | | 0.60-2.15 | 0.80-1.90 |
| 30%-35% | | 0.51-1.84 | 0.70-1.70 |
| 35%-40% | | 0.39-1.42 | 0.50-1.30 |
| 40%-45% | | 0.36-1.31 | 0.40-1.20 |
| 45%-100% | Second charging current | 0.33 | 0.33 |

As the SOC increases, each time an SOC interval is reached, the battery management system 122 adjusts the first charging current to correspondingly reduce the first charging current, where the first charging current can be any charging rate within a charging rate range corresponding to the SOC interval, so as to reduce a probability of the charging current exceeding the maximum allowable charging current of the battery 120. This lowers a probability of lithium precipitation in the battery 120, and extends a lifespan of the battery 120.

Example 1 is used as an example. When the SOC of the battery 120 was in a range of 0% to 5%, the battery 120 was charged at a charging rate in a range of 1.37C to 4.92C. When the SOC of the battery 120 was charged to a range of 5% to 10%, the battery 120 was charged at a charging rate in a range of 1.18C to 4.23C. When the SOC of the battery 120 was charged to a range of 10% to 15%, the battery 120 was charged at a charging rate in a range of 0.98C to 3.54C. When the SOC of the battery 120 was charged to a range of 15% to 20%, the battery 120 was charged at a charging rate in a range of 0.83C to 3.00C. When the SOC of the battery 120 was charged to a range of 20% to 25%, the battery 120 was charged at a charging rate in a range of 0.68C to 2.46C. When the SOC of the battery 120 was charged to a range of 25% to 30%, the battery 120 was charged at a charging rate in a range of 0.60C to 2.15C. When the SOC of the battery 120 was charged to a range of 30% to 35%, the battery 120 was charged at a charging rate in a range of 0.51C to 1.84C. When the SOC of the battery 120 was charged to a range of 35% to 40%, the battery 120 was charged at a charging rate in a range of 0.39C to 1.42C. When the SOC of the battery 120 was charged to a range of 40% to 45%, the battery 120 was charged at a charging rate in a range of 0.36C to 1.31C. When the SOC of the battery 120 was charged to exceed 45%, the battery 120 was charged at a charging rate of 0.33C.

It can be understood that the battery management system 122 could select any charging rate within a charging rate range corresponding to each SOC interval as a current magnitude for charging the battery 120, for example, randomly selecting a current magnitude within the range or selecting a current magnitude based on a pre-established rule.

The ranges described in the embodiments of this application all include endpoint values of the ranges. For example, a range [a, b] refers to a range greater than or equal to a and less than or equal to b.

In some embodiments, as shown in Table 1 and Table 2 above, the second charging current might be a constant current, for example, in a range of 0.3C to 1.0C. Further, optionally, the second charging current might be in a range of 0.33C to 0.8C, and 0.33C is used as an example below. That is, after the SOC of the battery 120 exceeded the SOC threshold, the battery 120 was charged in a manner of constant current charging, offering advantages such as high charging efficiency, ease of precise control, and reduction in damage to the battery 120 caused by overcharging, fast charging, or the like, thereby extending a lifespan of the battery 120.

Certainly, after the SOC of the battery 120 exceeded the SOC threshold, the battery 120 might alternatively be charged in a manner of constant voltage charging. In this case, the second charging current was not constant but gradually decreased.

Alternatively, after the SOC of the battery 120 exceeded the SOC threshold, the battery 120 might first be charged at the constant second charging current for constant current charging, and then the battery 120 was charged at a constant voltage for constant voltage charging to eliminate polarization.

This application does not limit a charging manner used after the SOC of the battery 120 exceeds the SOC threshold.

During a process of charging the battery 120 at the first charging current, an internal resistance of the battery 120 was utilized to generate heat, and a battery cell 121 with a larger capacity produced more heat. A higher temperature when the battery 120 reached the SOC threshold was more conducive to utilizing the capacity of the battery cell 121. Therefore, the charging scheme of the embodiments of this application is more suitable for a battery 120 with a large capacity. For example, in some embodiments, the capacity of the battery cell 121 in the battery 120 is in a range of 100 Ah to 300 Ah. Further, optionally, the capacity of the battery cell 121 can be in a range of 130 Ah to 250 Ah.

The capacity of the battery 120 was tested using different first charging currents, as shown in Table 3 and Table 4. A material of a negative electrode plate of the battery 120 used for testing was graphite, for example, including at least one of soft carbon, hard carbon, artificial graphite, and natural graphite. A graphite content of the negative electrode was 96.7%, a binder content was 1.5%, a coating weight of the negative electrode was 0.163 mg/1540 mm², a porosity was 27%, a coating thickness of the negative electrode was 0.216 mm, and a compacted density of the negative electrode was 1.65 g/cm³.

An electrolyte of the battery cell 121 was a solution being electronically insulating and ionically conductive, with one or more carbonate organic esters, such as ethylene carbonate, propylene carbonate, dimethyl carbonate, diethyl carbonate, and ethyl methyl carbonate being selected as solvents, and one or more lithium salts, such as LiPF₆, LiBF₄, LiBOB, LiAsF₆, Li(CF₃SO₂)₂N, LiCF₃SO₃, and LiClO₄ being selected as solutes.

A separator of the battery cell 121 was selected from a film made of one or more materials, such as polyethylene, polypropylene, non-woven fabric, and polyfiber, with electrochemical and chemical stability.

During a preparation process of a positive electrode plate of the battery cell 121, an active material LiMPO₄, conductive carbon black Super-P, and a binder PVDF were thoroughly mixed and stirred to uniformity in an NMP solvent system at a weight ratio of 97:1:2. Then, the resulting slurry was applied onto an Al foil with a controlled coating weight of 360 g/m², followed by drying, cold-pressing, slitting, and cutting to obtain a cathode plate.

During a preparation process of a negative electrode plate of the battery cell 121, graphite, conductive carbon black Super-P, and a binder SBR were thoroughly mixed and stirred to uniformity in an H2O solvent system at a weight ratio of 97.4:0.8:1.8. Then, the resulting slurry was applied onto a Cu foil with a controlled coating weight of 0.163 mg/1540 mm², followed by drying, cold-pressing, slitting, and cutting to obtain an anode plate.

In preparing the battery cell 121, a PE/PP/PE three-layer porous polymer film was used as a separator. The positive electrode plate, the separator, and the negative electrode plate were wound in sequence, with the separator controlled to be positioned between the positive electrode plate and the negative electrode plate for separation, and misalignment between the positive electrode plate and the negative electrode plate, as well as between the positive and negative electrode plates and the separator, was controlled during winding to obtain a jelly roll, namely an electrode assembly, after winding. The electrode assembly was welded to a top cover of the battery cell 121 via tabs, followed by processes such as placing into a housing, baking, electrolyte injection, and formation, to obtain a qualified battery cell 121. The battery cell 121 can be used as the battery 120 to be tested. That is, the battery 120 including only one battery cell 121 is used as an example.

The SOC threshold being 45% and the length of the SOC interval being 5% are still used as an example. For example, as shown in Table 3, in the comparative example, the second charging current, such as 0.33C, was consistently used to charge the battery 120 in a manner of constant current charging. In Example 1, Example 2, and Example 3, when the SOC of the battery 120 was less than or equal to 45%, the battery 120 was charged at the first charging current, and after the SOC was greater than 45%, the battery 120 was charged at the second charging current, such as 0.33C. Current values of the first charging currents corresponding to each SOC interval were different in Example 1, Example 2, and Example 3.

**Table 3**

| SOC interval | Charging stage | Comparative example (C) | Example 1 (C) | Example 2 (C) | Example 3 (C) |
|---|---|---|---|---|---|
| 0%-5% | First charging current | 0.33 | 4.10 | 2.00 | 1.50 |
| 5%-10% | | | 3.53 | 1.80 | 1.20 |
| 10%-15% | | | 2.95 | 1.70 | 1.10 |
| 15%-20% | | | 2.50 | 1.40 | 0.80 |
| 20%-25% | | | 2.05 | 1.20 | 0.80 |
| 25%-30% | | | 1.79 | 0.80 | 0.70 |
| 30%-35% | | | 1.54 | 0.70 | 0.50 |
| 35%-40% | | | 1.18 | 0.50 | 0.40 |
| 40%-45% | | | 1.09 | 0.40 | 0.40 |
| 45%-100% | Second charging current | | 0.33 | 0.33 | 0.33 |

In Example 1, Example 2, and Example 3, the first charging current decreased with the SOC interval, and when the SOC reached 45%, the battery 120 was charged at the second charging current, namely 0.33C. The first charging current was always greater than 0.33C. In the comparative example, the second charging current, such as 0.33C, was consistently used to charge the battery 120 in a manner of constant current charging.

In the comparative example, Example 1, Example 2, and Example 3, the batteries 120 were all tested under the same conditions in the following manners.

During a testing process of the battery 120, first, the battery 120 was placed at an ambient temperature, such as 25°C, for a period to acclimate. After the temperature of the battery 120 reached 25°C, the battery 120 was charged to a fully charged state with a specific current, and then left at that temperature for a certain duration for environmental acclimation until the temperature of the battery 120 reached 25°C. The battery 120 was discharged at a specific current in a manner of constant current discharging until a cut-off voltage of the battery 120 was reached. A capacity in the constant current discharge was taken as a nominal capacity of the battery 120.

Next, the battery 120 was placed at an ambient temperature, such as 25°C, for a period to acclimate. After the temperature of the battery 120 reached 25°C, the battery 120 was charged to a fully charged state with a specific current, and then left at that temperature for a certain duration for environmental acclimation until the temperature of the battery 120 reached 25°C. The nominal capacity of the battery 120 was divided into several equal parts, and then the battery 120 was discharged at a specific current to each equal part of capacity in a manner of constant current discharging. Between two consecutive dischargings, the battery 120 was left standing for a certain duration, such as 30 minutes or more. A terminal voltage value of the battery 120 was recorded after each standing. This process was repeated until electric power of the battery 120 was fully discharged.

At an ambient temperature of 25°C, the battery 120 was first discharged at a discharge rate of 0.1C until the voltage of the battery 120 equaled 2.0 V. This was recorded as 0% SOC. Currents corresponding to the comparative example, Example 1, Example 2, and Example 3 shown in Table 3 were respectively used to charge the batteries 120, and the temperatures and SOCs of battery cells 121 were collected during the charging process. Charging was stopped when the battery 120 was charged to a cut-off voltage, such as 4.1V, and a capacity obtained at this point was a charging capacity of the battery. After the temperature of the battery 120 returned to 25°C, the battery 120 was discharged at a current of 0.33C until the voltage of the battery 120 equaled 2.0 V, to obtain a discharging capacity of the battery 120.

As shown in Table 4, in the comparative example, when the battery 120 was charged at 0.33C until the SOC of the battery 120 reached 45%, the temperature of the battery 120 reached 28.0°C. In Example 1, the first charging current decreased with the SOC interval, and when the battery was charged at the first charging current until the SOC of the battery 120 reached 45%, the temperature of the battery 120 could reach 40.0°C. In Example 2, the first charging current decreased with the SOC interval, and when the battery was charged at the first charging current until the SOC of the battery 120 reached 45%, the temperature of the battery 120 reached 35.5°C. In Example 3, the first charging current decreased with the SOC interval, and when the battery was charged at the first charging current until the SOC of the battery 120 reached 45%, the temperature of the battery 120 reached 30.4°C.

**Table 4**

| | Temperature (°C) | Charging capacity (Ah) | Discharging capacity (Ah) |
|---|---|---|---|
| Comparative example | 28.0 | 162.7 | 162.1 |
| Example 1 | 40.0 | 173.2 | 172.5 |
| Example 2 | 35.5 | 168.9 | 168.4 |
| Example 3 | 30.4 | 166.3 | 165.8 |

Thus, when the battery 120 was charged at the first charging current in Example 1, Example 2, and Example 3, the temperature of the battery 120 when the SOC of the battery 120 reached 45% was higher than 28°C in the comparative example. Charging the battery 120 at the first charging current when the SOC of the battery 120 was less than or equal to 45% could effectively increase the temperature of the battery 120.

Moreover, in Example 1, Example 2, and Example 3, the first charging currents corresponding to a same SOC interval gradually decreased, and correspondingly, the temperatures of the batteries 120 when the SOCs of the batteries 120 reached 45% gradually decreased. Therefore, a larger first charging current resulted in a faster temperature rise of the battery 120.

In addition, it can be seen from Table 4 that a higher temperature of the battery 120 when the SOC of the battery 120 reaches 45% means a higher temperature during a charging stage following the SOC of the battery 120 exceeding 45%, and means a larger charging capacity and discharging capacity of the battery 120. In Example 1, Example 2, and Example 3, as the temperature reached by the battery 120 when the SOC is 45% gradually decreases, both the charging capacity and the discharging capacity of the battery 120 gradually decrease.

After reaching 45%, the battery 120 enters the charging plateau corresponding to the element Mn in the LiMPO₄ material. During the charging plateau stage corresponding to the element Mn, a delithiation speed of the positive electrode active material slows down, but increasing the temperature of the battery 120 during this stage facilitates lithium ion deintercalation, which is conducive to utilizing the capacity of the battery 120.

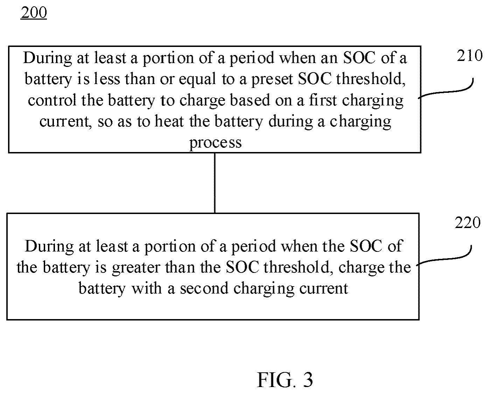

This application further provides a charging method 200 of a battery 120, used to charge the battery 120 described above. The method 200 may be performed, for example, by a battery management system 122. For example, as shown in FIG. 3, the method 200 includes some or all of the following steps.

Step 210: During at least a portion of a period when an SOC of the battery 120 is less than or equal to a preset SOC threshold, control the battery 120 to charge based on a first charging current, so as to heat the battery 120 during a charging process.

Step 220: During at least a portion of a period when the SOC of the battery 120 is greater than the SOC threshold, control the battery 120 to charge based on a second charging current, where the first charging current is greater than the second charging current.

In some embodiments, the first charging current is configured to decrease with the SOC of the battery 120.

In some embodiments, a range less than or equal to the SOC threshold includes multiple SOC intervals, where the multiple SOC intervals respectively correspond to multiple current values of a first charging current. The charging method further includes: determining a target current value corresponding to a target SOC interval, based on correspondences between the multiple SOC intervals and the multiple current values and the target SOC interval in which the SOC of the battery 120 is located. The controlling the battery 120 to charge based on a first charging current in step 210 includes: when the SOC of the battery 120 is within the target SOC interval, controlling the battery 120 to charge based on the target current value.

In some embodiments, a length of an SOC interval is in a range of 3% to 10%.

In some embodiments, a current value corresponding to each SOC interval among the multiple SOC intervals is less than or equal to a maximum allowable charging current of the battery 120 corresponding to a maximum SOC value within each SOC interval.

In some embodiments, the SOC threshold is determined based on a molar ratio of the element Fe in iron-manganese elements of the positive electrode active material. For example, the SOC threshold is a product of an SOC of the battery 120 in a fully charged state and the molar ratio.

In some embodiments, the second charging current is a constant current.

In some embodiments, a capacity of the battery 120 cell is in a range of 100 Ah to 300 Ah, or 130 Ah to 250 Ah.

It can be understood that for specific details of the charging method 200, reference may be made to the descriptions of the battery 120 above. For brevity, details are not repeated herein.

In the embodiments of this application, during the process of the battery management system 122 controlling charging of the battery 120, the battery management system 122 may send a charging instruction to a charging apparatus 110. The charging instruction may carry updated information about a first charging current to instruct the charging apparatus 110 to change the charging current. After receiving the charging instruction, the charging apparatus 110 changes a magnitude of the charging current input by the charging apparatus 110 to the battery 120, achieving adjustment of the charging current of the battery 120.

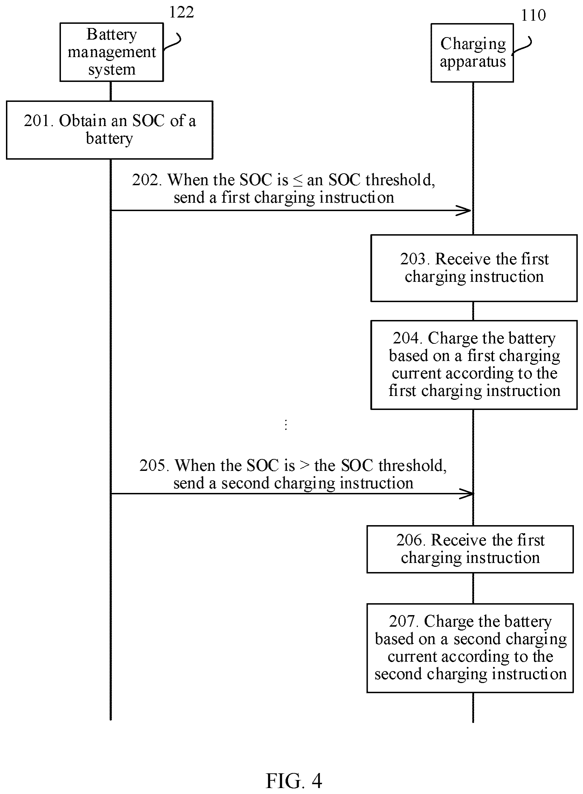

For example, FIG. 4 is a flowchart interaction diagram of a possible implementation of the charging method 200. Step 201: The battery management system 122 obtains the SOC of the battery 120.

Step 202: When the SOC of the battery 120 is less than or equal to the preset SOC threshold, the battery management system 122 sends a first charging instruction to the charging apparatus 110.

The first charging instruction carries the information about the first charging current.

Step 203: The charging apparatus 110 receives the first charging instruction.

Step 204: The charging apparatus 110 charges the battery 120 based on the first charging current according to the first charging instruction.

Step 205: When the SOC of the battery 120 is greater than the preset SOC threshold, the battery management system 122 sends a second charging instruction to the charging apparatus 110.

The second charging instruction carries information about a second charging current.

Step 206: The charging apparatus 110 receives the second charging instruction.

Step 207: The charging apparatus 110 charges the battery 120 based on the second charging current according to the second charging instruction.

Since first charging currents corresponding to multiple SOCs are different, when the SOC is less than or equal to the preset SOC threshold, each time the SOC of the battery 120 enters an SOC interval, the first charging instruction needs to be updated, and an updated first charging instruction carries information about a first charging current corresponding to an SOC interval in which a current SOC is located. FIG. 4 shows a case for only one SOC interval, where a corresponding first charging instruction carries a current value corresponding to the SOC interval.

From the above description, it can be seen that in the embodiments of this application, when the SOC of the battery 120 is less than or equal to the preset SOC threshold, the battery management system 122 controls the battery 120 to charge based on the larger first charging current, increasing the temperature of the battery 120 during the charging process, and when the SOC of the battery 120 exceeds the SOC threshold, controls the battery 120 to charge based on the conventional second charging current. The SOC threshold may be determined based on a molar ratio of the element Fe in iron-manganese elements in the positive electrode active material of the battery 120. In this way, upon entering the charging plateau stage corresponding to the element Mn, the battery has an appropriate temperature, enhancing a delithiation depth of the positive electrode active material LiMPO₄, thereby increasing the charging capacity of the battery and improving the charging performance of the battery. The range less than or equal to the SOC threshold includes the multiple SOC intervals, where the multiple SOC intervals respectively correspond to the multiple current values of the first charging current. The battery management system 122 determines the target current value corresponding to the target SOC interval, based on the correspondences between the multiple SOC intervals and the multiple current values and the target SOC interval in which the SOC of the battery 120 is located, and when the SOC of the battery 120 is within the target SOC interval, controls the battery 120 to charge based on the corresponding target current value, thereby effectively reducing occurrences such as lithium precipitation caused by the charging current exceeding the maximum allowable charging current of the battery 120 during the charging process.

The embodiments of this application may be applied to various types of batteries, particularly a battery 120 using a LiMPO₄ material as a positive electrode active material, where M in the LiMPO₄ material may include element Mn and element Fe. Below, the LiMPO₄ material is specifically described.

As one implementation of the LiMPO₄ material, LiMPO₄ may be a compound with a chemical formula LiMn_{1-y}Fe_{y}PO₄, where y is any value in a range of 0.001 to 0.5.

A compound LiMn_{0.80}Fe_{0.20}PO₄ is used as an example to describe a preparation method of the compound LiMn_{0.80}Fe_{0.20}PO₄. The preparation method may include, for example, the following steps.

Step S1: Prepare Fe-doped manganese oxalate.

For example, 919.4 g of manganese carbonate and 231.7 g of ferrous carbonate are added to a mixer and thoroughly mixed for 6 hours, and a resulting mixture is transferred to a reactor, where 5 L of deionized water and 1260.6 g of oxalic acid dihydrate are added. The resulting mixture is heated to 80°C, and thoroughly stirred at 500 rpm for 6 hours to uniformity until the reaction terminates with no bubbles produced, to obtain an Fe-doped manganese oxalate suspension. Then, the suspension is filtered, dried at 120°C, and subjected to sand milling to obtain manganese iron oxalate particles with a particle size of 100 nm.

Step S2: Prepare LiMn_{0.80}Fe_{0.20}PO₄.

For example, 1791.4 g of manganese iron oxalate (denoted as C₂O₄Mn_{0.80}Fe_{0.20}•2H₂O) prepared in step S1, 369.4 g of lithium carbonate, and 1150.1 g of ammonium dihydrogen phosphate are taken and added to 20 L of deionized water for thorough stirring. They are mixed to uniformity and react at 80°C for 10 hours to obtain a slurry. The slurry is transferred to a spray drying device for spray drying granulation, followed by drying at a temperature of 250°C to obtain powder. In a protective atmosphere, such as 90% nitrogen and 10% hydrogen, the powder is sintered in a roller kiln at 700°C for 4 hours.

In another implementation of the LiMPO₄ material, LiMPO₄ may be a compound with a chemical formula Li₁₊ₜMn_{1-c}Fe_{c}P_{1-z}R_{z}O₄, where t is any value in a range of -0.100 to 0.100, c is any value in a range of 0.001 to 0.500, z is any value in a range of 0.001 to 0.100, and R includes one or more elements selected from B, S, Si, and N.

The values of t, c, and z are configured to maintain electrical neutrality of the entire compound. Optionally, a ratio of c to 1-c may be 1:10 to 1:1, and further, 1:4 to 1:1. Herein, c represents a sum of stoichiometric numbers of the element Fe doped at the Mn site. Optionally, a ratio of z to 1-z may be 1:9 to 1:999, and further, 1:499 to 1:249. Herein, z represents a sum of stoichiometric numbers of the element R doped at the P site.

For example, a preparation method of a compound Li₁₊ₜMn_{1-c}Fe_{c}P_{1-z}R_{z}O₄ may include the following steps.

Step S1: Dissolve and stir a manganese source, an iron source, and an acid in a solvent to generate a suspension of a manganese salt doped with the element Fe, filter the suspension, and dry the filter cake to obtain a manganese salt doped with the element Fe.

Step S2: Add a lithium source, a phosphorus source, a source of element R, a solvent, and the manganese salt doped with the element Fe obtained from step S1 to a reaction vessel for grounding and mixing to obtain a slurry.

Step S3: Transfer the slurry obtained from step S2 to a spray drying device for spray drying granulation to obtain particles.

Step S4: Sinter the particles obtained from step S3 to obtain a positive electrode active material.

The manganese source is, for example, a manganese-containing substance that can be used to prepare lithium manganese phosphate, including but not limited to one or a combination of elemental manganese, manganese dioxide, manganese phosphate, manganese oxalate, and manganese carbonate. The iron source is, for example, selected from at least one of elemental iron, oxide, phosphate, oxalate, carbonate, and sulfate. The acid is, for example, selected from one or more of hydrochloric acid, sulfuric acid, nitric acid, phosphoric acid, and organic acid, such as oxalic acid. The source of the element R is, for example, selected from at least one of sulfate, borate, nitrate, and silicate of the element R.

A compound Li_{1.001}Mn_{0.999}Fe_{0.001}P_{0.999}Si_{0.001}O₄ is used as an example, and its preparation method may include:
Step S1: Prepare Fe-doped manganese oxalate.

For example, 1148.2 g of manganese carbonate and 1.2 g of ferrous carbonate are added to a mixer and thoroughly mixed for hours, and a resulting mixture is transferred to a reactor, where 5 L of deionized water and 1260.6 g of oxalic acid dihydrate are added. The resulting mixture is heated to 80°C, and stirred at 500 rpm for 6 hours for mixing to uniformity until the reaction terminates with no bubbles produced, to obtain an Fe-doped manganese oxalate suspension. Then, the suspension is filtered, dried at 120°C, and subjected to sand milling to obtain manganese iron oxalate particles with a particle size of 100 nm.

Step S2: Prepare Li_{1.001}Mn_{0.999}Fe_{0.001}P_{0.999}Si_{0.001}O₄.

1789.6 g of manganese iron oxalate (denoted as C₂O₄Mn_{0.999}Fe_{0.001}•2H₂O) prepared in step S1, 369.8 g of lithium carbonate, 1148.9 g of ammonium dihydrogen phosphate, and 0.8 g of silicic acid are taken and added to 20 L of deionized water for thorough stirring, and mixed to uniformity to react at 80°C for 10 hours to obtain a slurry. The slurry is transferred to a spray drying device for spray drying granulation, and dried at a temperature of 250°C to obtain powder. In a protective atmosphere, such as 90% nitrogen and 10% hydrogen, the powder is sintered in a roller kiln at 700°C for 4 hours.

In yet another implementation of the LiMPO₄ material, LiMPO₄ may be a compound with a chemical formula Li_{1+w}CₘMn₁₋ᵤFeᵤP₁₋ₐRₐO₄₋ₙDₙ, where C includes one or more elements selected from Zn, Al, Na, K, Mg, Nb, Mo, and W, R includes one or more elements selected from B, S, Si, and N, D includes one or more elements selected from S, F, Cl, and Br, w is any value in a range of -0.100 to 0.100, u is any value in a range of 0.001 to 0.500, a is any value in a range of 0.001 to 0.100, n is any value in a range of 0.001 to 0.1, and m is any value in a range of 0.9 to 1.1.

Similarly, the values of w, u, a, and m are configured to maintain electrical neutrality of the entire compound.

For example, a preparation method of the compound Li_{1+w}CₘMn₁₋ᵤFeᵤP₁₋ₐRₐO₄₋ₙDₙ may include the following steps.

Step S1: Dissolve and stir a manganese source, an iron source, and an acid in a solvent to generate a suspension of a manganese salt doped with the element Fe, filter the suspension, and dry the filter cake to obtain a manganese salt doped with the element Fe.

Step S2: Add a lithium source, a phosphorus source, a source of element C, a source of element R, a source of element D, a solvent, and the manganese salt doped with the element Fe obtained from step S1 to a reaction vessel for grounding and mixing to obtain a slurry.

Step S3: Transfer the slurry obtained from step S2 to a spray drying device for spray drying granulation to obtain particles.

Step S4: Sinter the particles obtained from step S3 to obtain a positive electrode active material.

The source of element C is, for example, selected from at least one of simple substance, oxide, phosphate, oxalate, carbonate, and sulfate of the element C. The manganese source is, for example, a manganese-containing substance that can be used to prepare lithium manganese phosphate, including but not limited to one or a combination of elemental manganese, manganese dioxide, manganese phosphate, manganese oxalate, and manganese carbonate. The iron source is, for example, selected from at least one of elemental iron, oxide, phosphate, oxalate, carbonate, and sulfate. The acid is, for example, selected from one or more of hydrochloric acid, sulfuric acid, nitric acid, phosphoric acid, and organic acid, such as oxalic acid. The source of element R is, for example, selected from at least one of sulfate, borate, nitrate, and silicate of the element R. The source of element D is, for example, selected from at least one of simple substance and ammonium salt of element D.

For a case where the positive electrode active material may contain Li_{1+w}CₘMn₁₋ᵤFeᵤP₁₋ₐRₐO₄₋ₙDₙ, a magnitude of x is influenced by valence states of Fe and R and magnitudes of y and z to ensure that the entire system maintains electrical neutrality. If a value of x is too small, a lithium content of the entire system decreases, affecting a specific capacity of the material. A value of y limits a total amount of all doping elements. If y is too small, that is, a doping amount is too low, the doping element has no effect, and if y exceeds 0.5, a Mn content of the system is low, affecting a voltage plateau of the material. The element R is doped at the P site. Since a P-O tetrahedron is relatively stable, and a value of z that is too large affects the stability of the material, a value of a is limited to 0.001 to 0.100. More specifically, w is any value in a range of -0.100 to 0.100, u is any value in a range of 0.001 to 0.500, a is any value in a range of 0.001 to 0.100, n is any value in a range of 0.001 to 0.1, and m is any value in a range of 0.9 to 1.1. For example, 1+x is selected from a range of 0.9 to 1.1, such as 0.97, 0.977, 0.984, 0.988, 0.99, 0.991, 0.992, 0.993, 0.994, 0.995, 0.996, 0.997, 0.998, or 1.01; x is selected from a range of 0.001 to 0.1, such as 0.001 or 0.005; y is selected from a range of 0.001 to 0.5, such as 0.001, 0.005, 0.02, 0.05, 0.1, 0.15, 0.2, 0.25, 0.3, 0.34, 0.345, 0.349, 0.35, or 0.4; z is selected from a range of 0.001 to 0.1, such as 0.001, 0.005, 0.08, or 0.1; n is selected from a range of 0.001 to 0.1, such as 0.001, 0.005, 0.08, or 0.1; and the positive electrode active material is electrically neutral.

Unless otherwise specified, in the above chemical formulas, when a doping site has two or more elements, a limitation on the numerical range of w, u, a, or m is not only a limitation on the stoichiometric number of each element at that site but also a limitation on a sum of stoichiometric numbers of the elements at that site. For example, in a case of a compound with a chemical formula Li_{1+w}Mn₁₋ᵤFeᵤP₁₋ₐRₐO₄, if R includes two or more elements R1, R2, ..., Rn, stoichiometric numbers z1, z2, ..., zn of R1, R2, ..., Rn, respectively must each fall within a numerical range limited for z in this application, and a sum of z1, z2, ..., zn must also fall within that numerical range. Similarly, if C includes two or more elements, a limitation on a numerical range of a stoichiometric number of C has the same meaning as above.

This application further provides a battery management system 122, configured to perform the charging method 200 of the battery 120 described in any of the above embodiments, where the battery 120 includes at least one battery cell 121, and a positive electrode active material of the battery cell 121 includes LiMPO₄, where M includes element Mn and element Fe.

This application further provides an electric device, including the battery 120 described in any of the above embodiments, where the battery 120 is configured to provide a power source for the electric device.

The electric device may be, for example, a mobile phone, a portable device, a notebook computer, an electric scooter, an electric toy, an electric tool, an electric vehicle, a ship, or a spacecraft, where the spacecraft includes an airplane, a rocket, a space shuttle, or a spaceship.

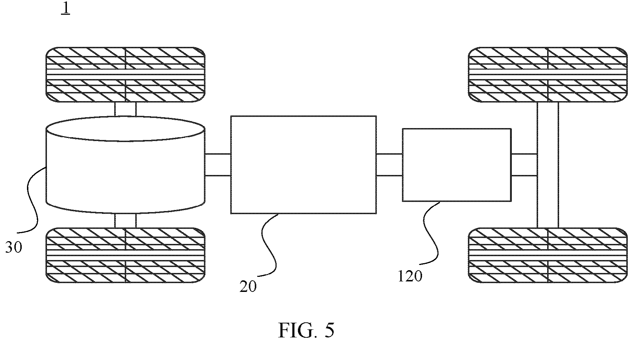

For example, FIG. 5 is a schematic structural diagram of a vehicle 1 according to an embodiment of this application. The vehicle 1 may be a fuel vehicle, a gas vehicle, or a new energy vehicle, and the new energy vehicle may be a battery electric vehicle, a hybrid electric vehicle, an extended range electric vehicle, or the like. A motor 30, a controller 20, and a battery 120 may be provided inside the vehicle 1, where the controller 20 is configured to control the battery 120 to supply power to the motor 30. For example, the battery 120 may be provided at the bottom, front, or rear of the vehicle 1. The battery 120 may be configured to supply power to the vehicle 1. For example, the battery 120 may be used as an operational power source for the vehicle 1 which is configured for a circuit system of the vehicle 1, for example, to satisfy power needs of start, navigation, and running of the vehicle 1. In another embodiment of this application, the battery 120 can be used not only as the operational power source for the vehicle 1, but also as a driving power source for the vehicle 1, replacing or partially replacing fossil fuel or natural gas to provide driving traction for the vehicle 1.

This application further provides a computer-readable storage medium, configured to store a computer program. When the computer program is executed by a computing device, the computing device implements the method performed by the battery management system 122 in any of the above embodiments. Optionally, the computer program may be a computer program in the battery management system 122 described above.

It should be noted that, under the premise that there is no conflict, the embodiments described in this application and/or technical features in the embodiments may be arbitrarily combined, and technical solutions obtained after combination should also fall within the protection scope of this application.

The magnitudes of the numbers of the processes in the above embodiments of this application do not imply the order of execution. The execution order of each process should be determined by its function and inherent logic and should not constitute any limitation on the implementation process of the embodiments of this application.

Persons of ordinary skill in the art may be aware that the units and algorithmic steps in the examples described with reference to the embodiments disclosed herein can be implemented by electronic hardware or a combination of computer software and electronic hardware. Whether these function are performed by hardware or software depends on particular applications and design constraints of the technical solutions. Persons skilled in the art may use different methods to implement the described functions for each particular application, but it should not be considered that the implementation goes beyond the scope of this application.

In the several embodiments provided in this application, it should be understood that the disclosed system, apparatus, and method may be implemented in other manners. For example, the described apparatus embodiment is merely an example. For example, division into the units is merely a logical function division, and another division manner may be used during actual implementation. For example, a plurality of units or components may be combined, or may be integrated into another system, or some features may be ignored or not performed. In addition, the displayed or discussed mutual couplings, direct couplings or communication connections may be indirect couplings or communication connections through some interfaces, apparatuses, or units, and may be in electrical, mechanical, or other forms.

Units described as separate components may or may not be physically separate. A component displayed as a unit may be one or more physical units, and may be located in one place, or may be distributed in a plurality of places. Some or all of the units may be selected based on an actual requirement, to achieve the objectives of the solutions in the embodiments.

Various implementation manners described in this specification may be implemented individually or in combination, and this is not limited in the embodiments of this application.

Although this application has been described with reference to the preferred embodiments, various modifications to this application and replacements of the components therein with equivalents can be made without departing from the scope of this application. In particular, as long as there is no structural conflict, the various technical features mentioned in the implementations can be combined in any manners. This application is not limited to the specific embodiments disclosed in this specification but includes all technical solutions falling in the scope of the claims.

## Claims

1. A battery **characterized by** comprising:
at least one battery cell, wherein a positive electrode active material of the battery cell comprises LiMPO₄, and M comprises element Mn and element Fe; and
a battery management system configured to:
during at least a portion of a period when an SOC of the battery is less than or equal to a preset SOC threshold, control the battery to charge based on a first charging current so as to heat the battery during a charging process; and
during at least a portion of a period when the SOC of the battery is greater than the SOC threshold, control the battery to charge based on a second charging current, wherein the first charging current is greater than the second charging current.

2. The battery according to claim 1, **characterized in that** the first charging current is configured to decrease with the SOC of the battery.

3. The battery according to claim 1 or 2, **characterized in that** a range less than or equal to the SOC threshold comprises multiple SOC intervals, the multiple SOC intervals respectively corresponding to multiple current values of the first charging current, and the battery management system is specifically configured to:
determine a target current value corresponding to a target SOC interval, based on correspondences between the multiple SOC intervals and the multiple current values and the target SOC interval in which the SOC of the battery is located; and
when the SOC of the battery is within the target SOC interval, control the battery to charge based on the target current value.

4. The battery according to claim 3, **characterized in that** a length of the SOC interval is in a range of 3% to 10%.

5. The battery according to claim 3 or 4, **characterized in that** a current value corresponding to each SOC interval among the multiple SOC intervals is less than or equal to a maximum allowable charging current of the battery corresponding to a maximum SOC value within each SOC interval.

6. The battery according to any one of claims 1 to 5, **characterized in that** the SOC threshold is determined based on a molar ratio of the element Fe in iron-manganese elements of the positive electrode active material.

7. The battery according to claim 6, **characterized in that** the SOC threshold is a product of an SOC of the battery in a fully charged state and the molar ratio.

8. The battery according to any one of claims 1 to 7, **characterized in that** the second charging current is a constant current.

9. The battery according to any one of claims 1 to 8, **characterized in that** a capacity of the battery cell is in a range of 100 Ah to 300 Ah, or 130 Ah to 250 Ah.

10. The battery according to any one of claims 1 to 9, **characterized in that** the positive electrode active material comprises at least one of the following materials:
LiMn_{1-y}Fe_{y}PO₄, wherein y is any value in a range of 0.001 to 0.5;
Li₁₊ₜMn_{1-c}Fe_{c}P_{1-z}R_{z}O₄, wherein t is any value in a range of -0.100 to 0.100, c is any value in a range of 0.001 to 0.500, z is any value in a range of 0.001 to 0.100, and R comprises one or more elements selected from B, S, Si, and N; and
Li_{1+w}CₘMn₁₋ᵤFeᵤP₁₋ₐRₐO₄₋ₙDₙ, wherein C comprises one or more elements selected from Zn, Al, Na, K, Mg, Nb, Mo, and W, R comprises one or more elements selected from B, S, Si, and N, D comprises one or more elements selected from S, F, Cl, and Br, w is any value in a range of -0.100 to 0.100, u is any value in a range of 0.001 to 0.500, a is any value in a range of 0.001 to 0.100, n is any value in a range of 0.001 to 0.1, and m is any value in a range of 0.9 to 1.1.

11. A charging method of a battery, **characterized in that** the battery comprises at least one battery cell, a positive electrode active material of the battery cell comprises LiMPO₄, M comprises element Mn and element Fe, and the charging method comprises:
during at least a portion of a period when an SOC of the battery is less than or equal to a preset SOC threshold, controlling the battery to charge based on a first charging current, so as to heat the battery during a charging process; and
during at least a portion of a period when the SOC of the battery is greater than the SOC threshold, controlling the battery to charge based on a second charging current, wherein the first charging current is greater than the second charging current.

12. The charging method according to claim 11, **characterized in that** the first charging current is configured to decrease with the SOC of the battery.

13. The charging method according to claim 11 or 12, **characterized in that** a range less than or equal to the SOC threshold comprises multiple SOC intervals, the multiple SOC intervals respectively corresponding to multiple current values of the first charging current, and the charging method further comprises:
determining a target current value corresponding to a target SOC interval, based on correspondences between the multiple SOC intervals and the multiple current values and the target SOC interval in which the SOC of the battery is located; and
the controlling the battery to charge based on a first charging current comprises:
when the SOC of the battery is within the target SOC interval, controlling the battery to charge based on the target current value.

14. The charging method according to claim 13, **characterized in that** a length of the SOC interval is in a range of 3% to 10%.

15. The charging method according to claim 13 or 14, **characterized in that** a current value corresponding to each SOC interval among the multiple SOC intervals is less than or equal to a maximum allowable charging current of the battery corresponding to a maximum SOC value within each SOC interval.

16. The charging method according to any one of claims 11 to 15, **characterized in that** the SOC threshold is determined based on a molar ratio of the element Fe in iron-manganese elements of the positive electrode active material.

17. The charging method according to claim 16, **characterized in that** the SOC threshold is a product of an SOC of the battery in a fully charged state and the molar ratio.

18. The charging method according to any one of claims 11 to 17, **characterized in that** the second charging current is a constant current.

19. The charging method according to any one of claims 11 to 18, **characterized in that** a capacity of the battery cell is in a range of 100 Ah to 300 Ah, or 130 Ah to 250 Ah.

20. The charging method according to any one of claims 11 to 19, **characterized in that** the positive electrode active material comprises at least one of the following materials:
LiMn_{1-y}Fe_{y}PO₄, wherein y is any value in a range of 0.001 to 0.5;
Li₁₊ₜMn_{1-c}Fe_{c}P_{1-z}R_{z}O₄, wherein t is any value in a range of -0.100 to 0.100, c is any value in a range of 0.001 to 0.500, z is any value in a range of 0.001 to 0.100, and R comprises one or more elements selected from B, S, Si, and N; and
Li_{1+w}CₘMn₁₋ᵤFeᵤP₁₋ₐRₐO₄₋ₙDₙ, wherein C comprises one or more elements selected from Zn, Al, Na, K, Mg, Nb, Mo, and W, R comprises one or more elements selected from B, S, Si, and N, D comprises one or more elements selected from S, F, Cl, and Br, w is any value in a range of -0.100 to 0.100, u is any value in a range of 0.001 to 0.500, a is any value in a range of 0.001 to 0.100, n is any value in a range of 0.001 to 0.1, and m is any value in a range of 0.9 to 1.1.

21. A battery management system configured to perform the charging method of the battery according to any one of claims 11 to 20, wherein the battery comprises at least one battery cell, a positive electrode active material of the battery cell comprises LiMPO₄, and M comprises element Mn and element Fe.

22. An electric device **characterized by** comprising the battery according to any one of claims 1 to 10.

23. A computer-readable storage medium configured to store a computer program, wherein when the computer program is executed by a computing device, the computing device implements the charging method of the battery according to any one of claims 10 to 20.
